(19) Europäisches Patentamt
European Patent Office
Office européen des brevets

(11) Publication number : 0 194 470 B1

# (12) EUROPEAN PATENT SPECIFICATION

(45) Date of publication of patent specification : 30.01.91 Bulletin 91/05

(51) Int. Cl.[5] : G03F 7/09, H01L 21/027

(21) Application number : 86102031.1

(22) Date of filing : 18.02.86

## (54) Method and composition of matter for improving conductor resolution of microelectronic circuits.

(30) Priority : 11.03.85 US 710746

(43) Date of publication of application : 17.09.86 Bulletin 86/38

(45) Publication of the grant of the patent : 30.01.91 Bulletin 91/05

(84) Designated Contracting States : DE FR GB IT

(56) References cited :
EP-A- 0 140 273
EP-A- 0 187 517
DE-A- 1 597 597
JP-A-60 009 124
US-A- 2 481 770
US-A- 4 093 461
US-A- 4 370 405
IEEE TRANSACTIONS ON ELECTRON DEVICES, vol. ED-28, no. 11, November 1981, pages 1405-1410, IEEE, New York, US; M.M. O'TOOLE et al.: "Linewidth control in projection lithography using a multilayer resist process"
SOLID-STATE TECHNOLOGY, vol. 27, no. 6, June 1984, pages 155-160, Port Washington, New York, US; E. ONG et al.: "Multilayer resists for fine line optical lithography"
JOURNAL SIGNAL AM, vol. 9, no. 5, 1981, pages 357-365, Akademie-Verlag, Berlin, DD; M. SCHARF et al.: "Modellbetrachtungen zur Vermeidung des Reflexionslichthofes von streuenden und nichtstreuenden photographischen Schichten"
PATENT ABSTRACTS OF JAPAN, vol. 7, no. 140 (E-182)[1285], 18th June 1983; & JP-A-58 52 820
IBM TECHNICAL DISCLOSURE BULLETIN, vol. 25, no. 2, July 1982, page 768, New York, US; J. DURAN et al.: "Applications of polyimides as lithographic resists"
PATENT ABSTRACTS OF JAPAN, vol. 5, no. 73 (P-61)[745], 15th May 1981; & JP-A-56 22 428

(56) References cited :
PATENT ABSTRACTS OF JAPAN, vol. 8, no. 228 (P-308)[1665], 19th October 1984; & JP-A-59 107 346

(73) Proprietor : International Business Machines Corporation
Old Orchard Road
Armonk, N.Y. 10504 (US)

(72) Inventor : Fredericks, Edward Carmine
8632 Ambrose Court .
Manassas, VA 22110 (US)
Inventor : Via, Giorgio Giulio
5954 Woodacre Court
McLean, VA (US)

(74) Representative : Kreidler, Eva-Maria, Dr. rer. nat.
Schönaicher Strasse 220
D-7030 Böblingen (DE)

EP 0 194 470 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to processes for manufacturirg microelectronic semiconductor devices. Specifically, a method is described for improving, during the manufacture of semiconductor integrated circuits in photolithographic processes, the line resolution of circuit conductors.

Microelectron circuit techniques have been developed which permit a high density electronic circuit to be incorporated in an integrated circuit. These techniques utilize a photo etching process wherein layers of circuit elements are provided on a substrate. The technology for manufacturing integrated circuits in accordance with these techniques has progressed to the point where submicron geometries are possible, permitting increased circuit density for a given substrate area.

The high density integrated circuits are multilayer structures which include layers of metallization which interconnect different components of a given layer on a substrate. The interconnecting metal deposits are formed by both subtractive and additive metal deposition techniques.

In an additive deposition technique, photoresist is applied to a surface of a substrate. A first layer of conductor elements are patterned on a photoresist material. The photoresist material is exposed through an image mask, such that certain areas of the resist are exposed to light, and other areas are masked from light. The exposed areas are subsequently removed, leaving mesas of photoresist interspaced by the areas formerly occupied by exposed photoresist material. A subsequent metallization of the processed surface provides for metal deposits which lie between the mesas in the areas formerly occupied by the exposed photoresist. The mesas, with the accompanying deposited metal, are subsequently removed. An insulation layer is deposited over the remaining metallic layers, and yet another layer of metallization may be formed on the resulting planarization layer.

The various techniques for manufacturing multilayer integrated circuits which utilize photoresist processes for defining the geometry of subsequent metallized surfaces are subject to resolution limitations. As each additional layer is formed on the multilevel integrated circuit, a subsequent layer of photoresist is patterned and exposed by an image mask. The exposed resist areas transmit a portion of light to the underlayer insulation which separates the metal layers and refracts another portion upwards at the boundary of the insulation and photoresist. The light transmitted through the exposed photoresist layer passes through the substrate and is reflected from the undersurface which may be a highly reflective layer of metal deposition. As such, the developed pattern of conductors for the upper levels of a multilayer integrated circuit suffer from the effects of scattered light from the photoresist/insulator boundary layer, as well as reflected light from the underlayers. The scattered and reflected light diminishes the resolution of the conductive layers formed over these surface layers. Such limitations in resolution inhibit the manufacture of integrated circuits of increased density.

Two techniques for avoiding these process limitations are described in U.S. Patent Nos. 4,370,405 and 4,362,809. In U.S. Patent 4,370,405, a suitable dye is interposed between a layer of resist and planarizing layer to absorb light which is transmitted through the photoresist. In U.S. Patent No. 4,362,809, a similar dye is utilized which is selected to absorb light of a wavelength used to expose the top resist layer but permits light to enter at another wavelength to expose a bottom resist layer. Wavelengths of light used to expose the top layer are absorbed in the dye. During exposure of a bottom layer, the light of a different wavelength is permitted to pass through the bottom resist layer and dye.

The present invention provides yet another technique for reducing the effects of underlayer reflections on upper photoresist layers in processes for manufacturing multilevel integrated circuits.

It is an object of this invention to reduce the effects of light scattering and reflections from under layers on subsequent surface circuit layers in a multi-layer integrated circuit.

It is a more specific object of this invention to provide a permanent planarization layer of insulating material between conductor layers in a multilayer integrated circuit which reduces light scattering, with an adjacent upper layer and absorbs reflected light from the bottom layer.

These and other objects of the invention are achieved by a process according to claim 1.

The insulation layer is permanent, not requiring removal during integrated circuit manufacture. The method of the invention produces a planarization layer of said insulation composition which reduces boundary interface scattering with an upper photoresist layer, as well as absorbing light reflections from under layers.

The insulation composition according to the invention includes a polymer of the chemical reaction of pyromellitic anhydride and a base. Added to this material is a quantity of a photo active compound to reduce the index of refraction of the mixture to more closely match the index of refraction of the subsequently formed layer of photoresist.

The method in accordance with the invention provides for a permanent polyimide planarization layer on a multilayer intergrated circuit. The planarization layer resides above other circuit layers which reflect incident light. A layer of photoresist is formed over the planarization layer. Circuit defining structure is imaged through the mask onto the photoresist. During

exposure of the photoresist, incident light passes through the planarization layer. Scattering from the boundary of the planarization layer and photoresist is minimized because the index of refraction of the planarization layer is substantially equal to the index of refraction of the photoresist. Light reflected from the underlying layers is substantially absorbed by the planarization layer. Reduction of the reflected and scattered light results in improved resolution of developed images in photoresist. The developed images, when further processed into interconnecting conductors have improved definition, avoiding the additional process steps of applying a temporary dye or other light impervious layer.

Figure 1 illustrates the steps in forming, through one type of additive metal deposition process, interconnecting metallic conductors.

Figure 2 is a cross-section of a multilevel integrated circuit illustrating three separate metal conducting layers.

Figure 3 illustrates the photoresist process used in forming the second metallization layer of Figure 2.

Figure 4 illustrates the effects of underlayer reflections and boundary scattering on unexposed portions of a mask imaged on a photoresist layer.

Figure 5 illustrates the effect of doping polyimide compounds with a photoactive compound on the index of refraction of the doped compounds.

Referring now to Figure 1, there is shown a set of process sequences A through E forming through an additive metal deposition process a first metallization layer on an integrated circuit substrate. The first of the steps, step (a), is shown to include coating a substrate 12 with a photoresist material 11 in a 1-3 micron thickness. The photoresist 11 is subsequently exposed to a mask image. The mask image provides for exposure of certain areas of the photoresist, identifying surface areas to be removed, and an unexposed portion which will not be removed. Process step (b), shown in Figure 1, illustrates the exposed and unexposed areas of the resist 11. The substrate is then baked before removing the exposed areas.

Process step (c) provides for removal of the exposed resist material by first flooding it with ultraviolet light. Once those areas are exposed to ultraviolet light, they become soluble. Once treated with a solvent they are dissolved. A metal deposition of the substrate is effected in process step (d). Process step (d) will provide for metallization in those areas formerly occupied by the exposed photoresist, as well as the surface of the unexposed resist 13 shown as upstanding mesas. The metallization may be applied through vacuum sputtering techniques to a thickness of .5 microns to 2.0 microns.

As a final step (e) in the additive metal deposition process of Figure 1, the remaining mesas and deposited metal are removed in a known metal lift-off technique. This lift-off technique utilizes hot solvents to remove the metallized mesas.

Adjacent conductor layers may be formed over the first formed metallic layer to achieve a multi-layer structure as shown in Figure 2. Prior to forming another metallic layer through steps (a)-(e) a planarization layer 16, 17 of insulation is placed over the metallized layer to separate the next formed metal layer from the adjacent under layer. Each metallized area is separated by the planarization layer of insulation. Over each planarization layer 16, 17, are formed the second and third metallization layers 19 and 20. The effects of surface boundary scattering and underlayer reflections, in forming the second and third metallization layers 19 and 20, are shown more particularly with reference to Figures 3 and 4.

Referring now to Figures 3 and 4, there is shown substrate 12 and the first metallization layer 13. A layer of insulation material 16, forming a planarization layer over the first metallization layer 13, supports a photoresist layer 18. The photoresist layer 18 is exposed with an image, formed from a mask 21 through a reducing lens 22. The result of exposing photoresist material 18 is shown in Figure 4. Each of the rays which travel through the exposed areas of the photoresist 18 can be seen to include a scattered component as well as a transmitted component, as shown in Figure 4. The transmitted component is incident to the underlayer of the first metallization layer, and is reflected back towards the photoresist layer 18. A consequence of the reflected ray and scattered ray is to expose the regions of the photoresist layer 18, which are masked. This unintentional exposure of the masked regions of the photoresist layer 18 is a reduction in definition of the unexposed area of the photoresist layer 18. As the definition of the unexposed photoresist area ultimately determines the conductor line width definition, the scattered and reflected light limits the conductor resolution possible with the photo etching techniques. These effects can be seen as round corners 18a and 18c in the formed mesas.

The process of the present invention provides for an insulation layer which reduces the scattered and reflected components. The insulation layer is composed to have an index of refraction approaching that of the upper photoresist layer, so that scattered light from the boundary of the insulation and photoresist is reduced. Further, the material has absorptive properties, which reduce the amount of reflected light ultimately reentering the photoresist layer 18.

The insulation layer comprises a polyimide. The polyimide material is a polymer mixture of the chemical reaction of pyromellitic anhydride and a base. Polyamic acid which is available from DuPont may be heated to produce a polyimide. Other suppliers of the polyimide material, useful for forming a major ingredient of the insulation material, include Ciba Geigy or Upjohn. The material is sold under the designation

polyimide.

The polyimide material is doped with a material which will provide for a resulting index of refraction approaching that of the upper photoresist layer. The doping of the polyimide, in accordance with the preferred embodiment, comprises adding a photoactive compound to the polyimide in a proportion such that the concentration of the photoactive compound in the resulting mixture of polyimide and photoactive compound is approximately 5%, but preferably less than 10%. Shown in Figure 5 is a graph of the index of refraction of the resulting material as a function of the per cent by weight of photoactive compound added to the polyimide planarization layer.

The main class of photoactive compounds, which may be selected for mixture with the polyimides, are the diazo-oxonaphthalenes. Preferably, the photoactive compound is a 2-diazo-1-oxo-naphthalene, or a 1-diazo-2-oxo-naphthalene, which may contain a sulfonic acid group or an ester of sulfonic acid at the 4 or 5 positions on the naphthalene ring. The photoactive compounds are mixed in proportions larger than naturally occurring impurities. Such photoactive compounds are available from the Aldrich Chemical Company, or Eastman Chemical Company, under the aforementioned designation. Preferably, the 2-diazo-1-oxo-naphthalene sulfonic acid is an ester of an ethylene glycol having the chemical formula

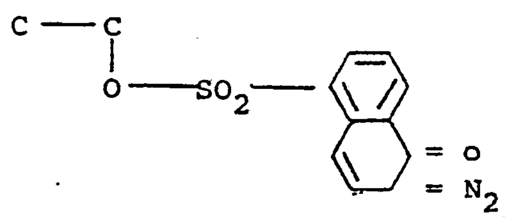

Generally, the diazo-oxo-naphthalenes are added to esterify an acid molecule. Preferably, the acid molecule contains a moiety based on benzene, or a polyaromatic molecule such as naphthalene, phenanthrene, pyrrone and benzophenone. A commercially available dye such as alizarin yellow A from Ciba Geigy can serve as the base carrier molecule to which the diazo-oxo-naphthalenes are chemically bonded in stoichiometric quantities.

The photoactive compounds may comprise a mixture of photoactive compounds and a Novolak polymer in concentrations greater than naturally occurring impurities. This mixture is commonly found in photoresist mixtures such as described in U.S. Patent No. 3,920,483 and U.S. Patent No. 4,464,458.

The formulations of a photoactive compound may contain certain additives present in the photoresist prior to adding to polyamic acid, in amounts generally one (1%) percent or less of photoresist dry weight. Examples are anhydride for photoresist speed and adhesion enhancement as described in U.S. Patent Nos. 4,009,033 and 4,036,644, as well as peroxides for speed enhancement as described in U.S. Patent Nos. 4,259,430 and 4,089,766.

When forming the composition serving as the planarization layer of insulation 16, the polyimide and photoactive compounds are mixed in the aforementioned percentages in accordance with Figure 5. The mixture is heated to approximately 150 to 250°C, preferably 200°, for 20-30 minutes. The composition may be added to the substrate covering a given metallization layer by spinning to a thickness of 1 1/2 to 4 μm. The resulting material is a planarization layer of insulation 16 which has excellent insulative properties as well as a good release or adhesion layer underneath the photoresist being developed. The planarization layer of insulation has excellent insulation, as well as providing for absorption of light rays which are reflected back through the insulation/planarization layer 16.

The foregoing composition of insulation material works well with current ultraviolet, 365 to 505 nm. (and mid ultraviolet at 280 to 350 nm.) exposure tools. The material is a permanent layer for insulating the subsequent metallization layer from the first metallization layer. The insulating layer 16 may be patterned with photoresist having a pattern of holes. The holes may be etched with a poly-layer reactive ion etch. The holes so formed may provide interconnection between metal layers when a subsequent metallization layer is formed over the planarization layer 16.

Although the foregoing process for providing a planarization layer which reduces boundary surface light scattering, and absorbs reflected light from under layers has been described in connection with an additive metal deposition process, the insulation composition may be utilized in other processes where it is necessary to reduce boundary scattering and under layer surface reflections from overexposing a photoresist layer.

Thus there is described a method and composition of matter useful for forming a planarization layer of insulation in a multilayer integrated circuit.

## Claims

1. Process for manufacturing integrated circuits having multiple metallic layers, wherein each metallic layer is formed during a photolithographic process comprising a method for reducing resolution limiting reflections from a bottom metallic layer during the photolithographic process by
depositing a permanent insulation layer of polyimide (16) over a bottom of metallic layer (13), said polyimide layer (16) including a photoactive compound, selected from 2-diazo1-oxo-naphthalene, 1-diazo-2-oxo-naphthalene and acids or an ester thereof, and said layer (16) being composed to have an optical index of refraction which approaches the

index of refraction of an upper photoresist layer (18).

2. Process of claim 1 wherein the percentage of said photoactive compound to polyimide insulation is less than 10% by weight.

3. Process of claim 2 wherein the percentage of said photoactive compound to polyimide insulation is 5% by weight.

4. Process of claim 1 wherein said polyimide layer additionally contains a Novolak polymer.

## Ansprüche

1. Verfahren zur Herstellung integrierter Schaltungen mit einer Vielzahl metallischer Schichten, wobei jede metallische Schicht in einem photolithographischen Verfahren gebildet wird, das ein Verfahren zur Reduzierung von die Auflösung begrenzenden Reflexionen einer unteren metallischen Schicht während des photolithographischen Verfahrens umfaßt
Aufbringen einer ständigen Isolationsschicht aus Polyimid (16) auf einer unteren metallischen Schicht (13), wobei besagte Polyimidschicht (16) eine aus der Gruppe 2-Diazo-1-oxo-naphthalin, 1-Diazo-2-oxo-naphthalin und Säuren oder eines Esters derselben ausgewählte photoaktive Zusammensetzung umfaßt, und besagte Schicht (16) einen optischen Brechungsindex aufweist, der dem der unteren Photoresistschicht (18) entspricht.

2. Verfahren nach Anspruch 1, wobei der Prozentsatz besagter photoaktiver Zusammensetzung im Verhältnis zur Polyimidisolation weniger als 10 Gewichtsprozent beträgt.

3. Verfahren nach Anspruch 2, wobei der Prozentsatz besagter photoaktiver Zusammensetzung im Verhältnis zur Polyimidisolation 5 Gewichtsprozent beträgt.

4. Verfahren nach Anspruch 1, wobei besagte Polyimidschicht zusätzlich ein Novolakpolymer enthält.

## Revendications

1. Procédé de fabrication de circuits intégrés ayant de multiples couches métalliques, dans lequel chaque couche métallique est formée au cours d'un procédé photolithographique, caractérisé en ce qu'il comprend une méthode pour réduire des reflexions imitant la résolution provenant d'une couche métallique inférieure pendant le procédé photolithographique par
dépôt d'une couche d'isolation permanente de polyimide (16) sur un fond de couche métallique (13), cette couche de polyimide (16) comprenant un composé photoactif, choisi parmi le 2-diazo-1-oxo-naphtalène, le 1-diazo-2-oxo-naphtalène et leurs acides ou un ester de ceux-ci, et cette couche (16) étant composée de façon a avoir un indice de réfraction optique qui est voisin de l'indice de réfraction d'une couche supérieure de photoréserve (18).

2. Procédé suivant la revendication 1, caractérisé en ce que le rapport en pourcentage de ce composé photoactif au polyimide d'isolation est inférieur à 10% en poids.

3. Procédé suivant la revendication 2, caractérisé en ce que le rapport en pourcentage de ce composé photoactif au polyimide d'isolation est de 5% en poids.

4. Procédé suivant la revendication 1, caractérisé en ce que cette couche de polyimide contient de plus un polymère novolaque.

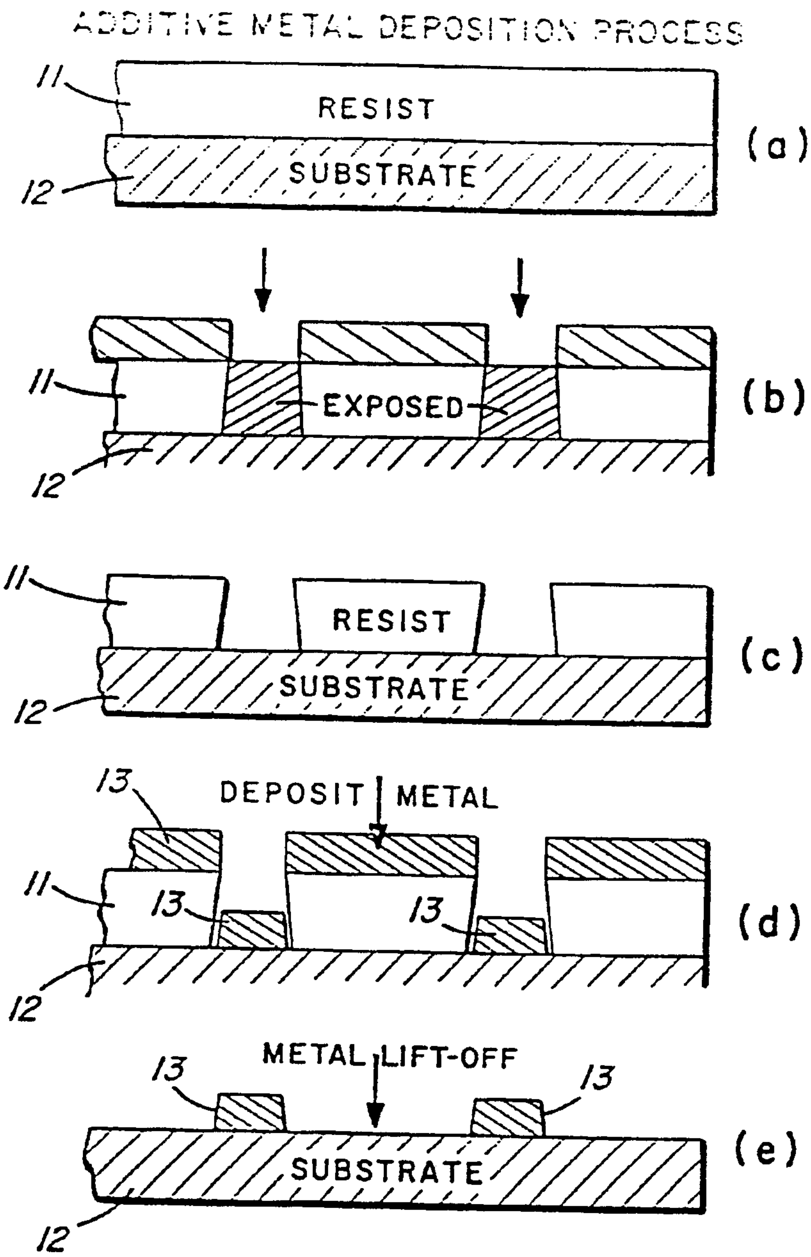


FIG. 1
PRIOR ART

FIG. 2

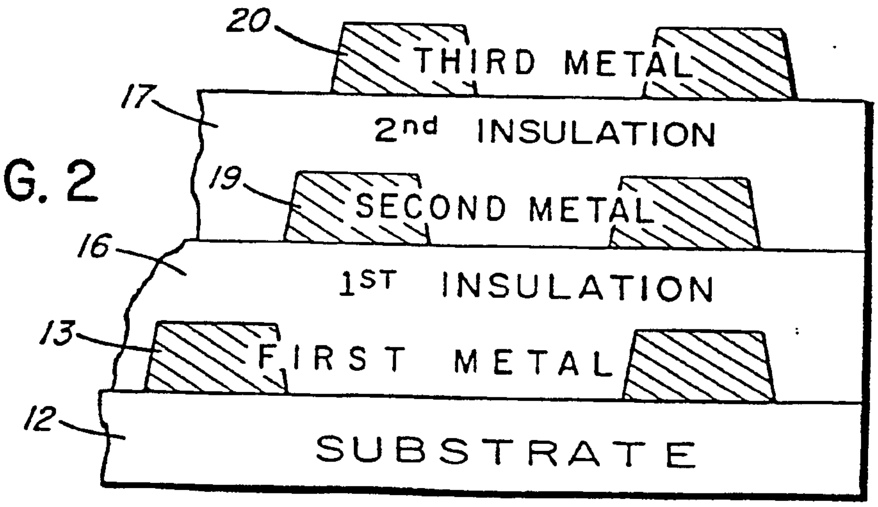

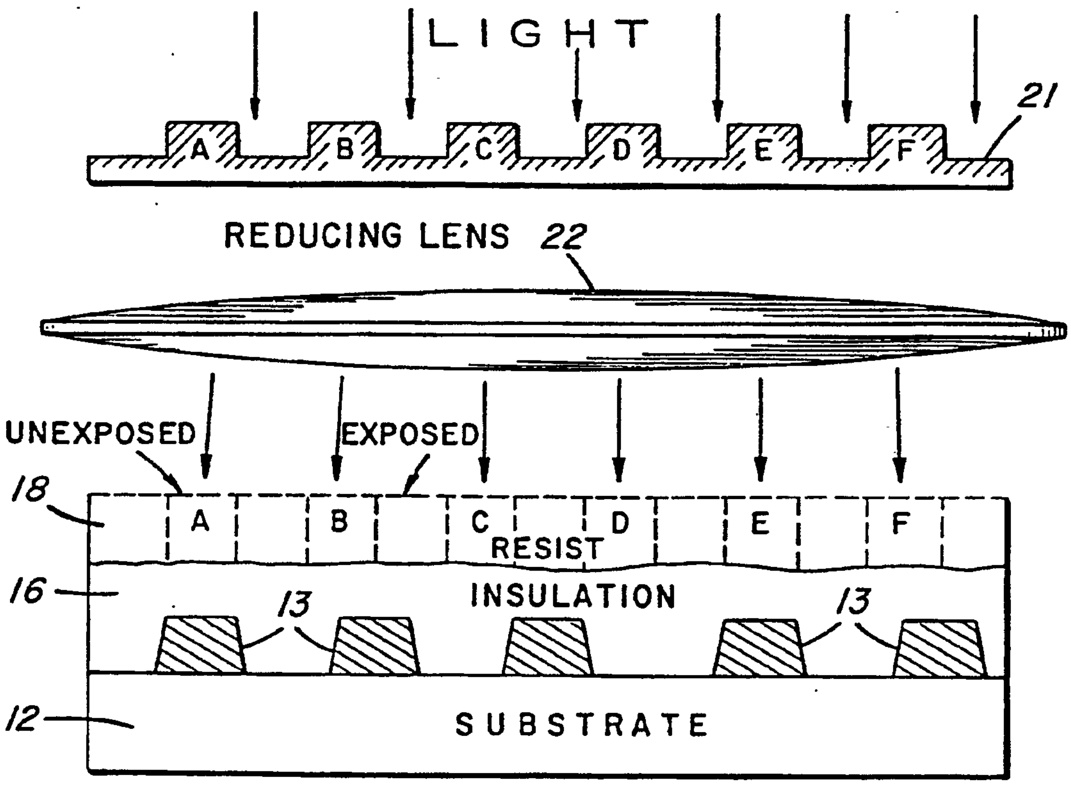


FIG. 3

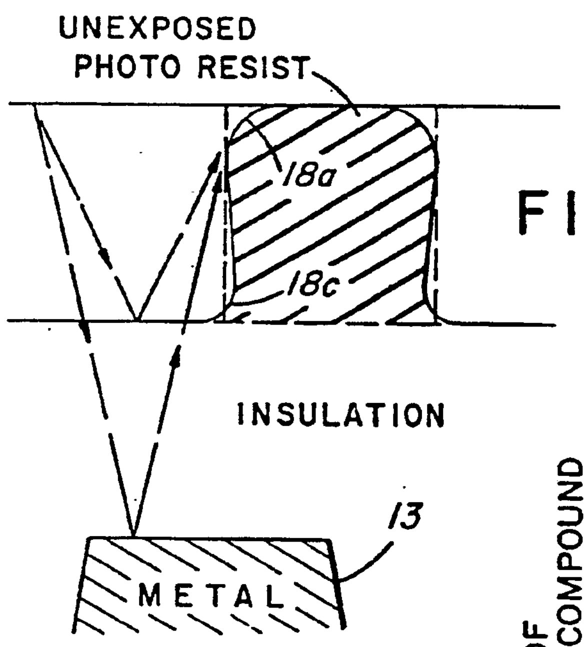


FIG. 4

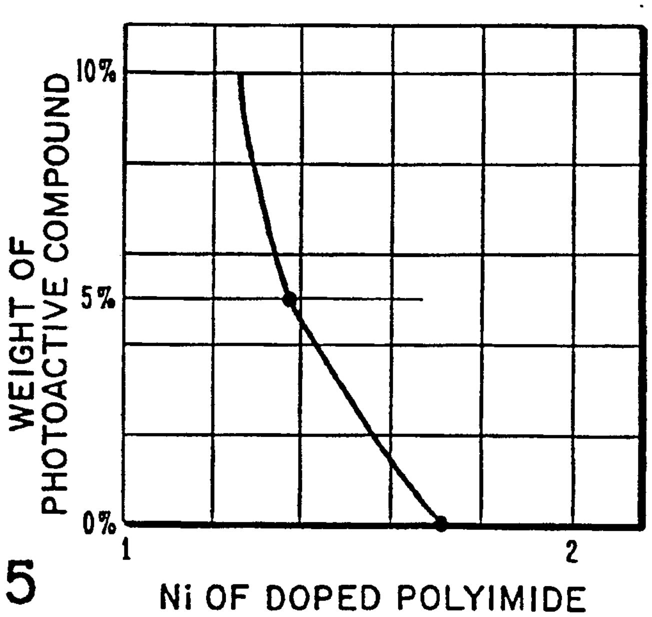


FIG. 5